# EUROPÄISCHE PATENTSCHRIFT

(11) **EP 1 421 677 B1**
(45) Veröffentlichungstag und Bekanntmachung des Hinweises auf die Patenterteilung: **16.03.2005**
(21) Anmeldenummer: 02772029.1
(22) Anmeldetag: 29.08.2002
(51) Int. Cl.: H03D 7/16

(54) **SENDEANORDNUNG, INSBESONDERE FÜR DEN MOBILFUNK**
TRANSMITTER SYSTEM, ESPECIALLY FOR CELLULAR TELEPHONY
SYSTEME EMETTEUR, NOTAMMENT POUR LA TELEPHONIE MOBILE

(30) Priorität: 29.08.2001 DE 10142248
(43) Veröffentlichungstag der Anmeldung: 26.05.2004
(73) Patentinhaber: Infineon Technologies AG, 81669 München (DE)
(72) Erfinder: GREWING, Christian, 40489 Düsseldorf (DE); HANKE, André, 40489 Düsseldorf (DE); VAN WAASEN, Stefan, 47178 Duisburg (DE)
(74) Vertreter: Epping - Hermann - Fischer
(86) Internationale Anmeldenummer: PCT/DE2002/003168
(87) Internationale Veröffentlichungsnummer: WO 2003/019769

(56) Entgegenhaltungen:
- WO-A-01/58103
- US-A- 5 861 781
- US-A- 6 016 422

## Beschreibung

Die vorliegende Erfindung betrifft eine Sendeanordnung, insbesondere für den Mobilfunk.

In Sendeanordnungen zur digitalen Kommunikation über Funk, welche für hohe Datenübertragungsraten ausgelegt sind, wird das zu sendende Nutzsignal, das sogenannte Modulationssignal, üblicherweise auf einer niedrigen Zwischenfrequenz bereitgestellt. Ein derartiges, komplexwertiges Signal mit Inphaseund Quadratur-Komponente wird üblicherweise mit einem sogenannten IQ-Vektormodulator auf einen hochfrequenten Träger aufmoduliert und über einen Funkkanal gesendet. Demnach muß sowohl das Modulationssignal als auch das den Modulator ansteuernde Lokaloszillator-Signal, welches die Trägerfrequenz aufweist,.zerlegt in Inphase- und Quadratur-Komponente vorliegen.

Inphase- und Quadratur-Komponente eines komplexwertigen Signals sind zueinander um 90° phasenverschoben und stehen damit zueinander orthogonal oder in Quadratur.

Das Lokaloszillator-Signal mit der Trägerfrequenz wird bei einem sogenannten Aufwärts-Mischprinzip üblicherweise mit einem spannungsgesteuerten Oszillator auf einer niedrigeren Frequenzebene erzeugt und anschließend mit einem zusätzlichen Frequenzmischer auf die gewünschte Trägerfrequenz hochgemischt. Zwischen dem Oszillator und dem Aufwärtsmischer ist dabei beispielsweise ein Frequenzteiler vorgesehen, der neben einer Frequenzteilung zusätzlich ein in zwei 90° zueinander phasenverschobene Signalkomponenten zerlegtes Signal bereitstellt, welches im nachgeschalteten Aufwärtsmischer, beispielsweise einem Spiegelfrequenz unterdrückenden Mischer, auf die gewünschte Lokaloszillatorfrequenz oder Trägerfrequenz hochgemischt wird.

Die Modulation eines Zwischenfrequenzsignals mit geringer Zwischenfrequenz (Low IF, IF=Intermediate Frequency) oder einer Zwischenfrequenz von 0 (Zero IF) erfordern hohe Paarungstoleranzen von Bauelementen (Matching) sowie geringe Toleranzabweichungen der Bauelementwerte im Sendepfad eines Mobilfunksenders, um eine ausreichende Unterdrückung der Spiegelfrequenz des Modulationssignals zu erreichen. Im Massenherstellungsverfahren sind derartige geringe Bauelementtoleranzen jedoch nicht oder nicht ohne zusätzlichen Aufwand erzielbar.

Aufgabe der vorliegenden Erfindung ist es, eine Sendeanordnung, insbesondere für den Mobilfunk anzugeben, welche bei einfachem Aufbau für eine Erzeugung eines Lokaloszillatorsignals durch Aufwärtsmischen geeignet ist und die zugleich den Einsatz von Spiegelfrequenz unterdrückenden Mischern ermöglicht.

Erfindungsgemäß wird die Aufgabe gelöst durch eine Sendeanordnung, insbesondere für den Mobilfunk, aufweisend
- einen Nutzsignaleingang zum Zuführen eines komplexwertigen Modulationssignals,
- einen Bezugssignaleingang zum Zuführen eines komplexwertigen Bezugssignals mit einer Bezugsfrequenz,
- einen ersten spiegelfrequenzunterdrückenden Mischer und einen zweiten spiegelfrequenzunterdrückenden Mischer, die jeweils mit dem Modulationssignal und einem vom abgeleiteten Signal Bezugssignal so angesteuert sind, daß die an ihren Ausgängen bereitgestellten Signalkomponenten zueinander um 90° phasenverschobene sind und gemeinsam ein komplexwertiges, moduliertes Zwischenfrequenzsignal bilden und
- einen Frequenzumsetzer, der mit einem ersten Eingang mit dem Bezugssignaleingang und mit einem zweiten Eingang mit den Ausgängen der spiegelfrequenzunterdrückenden Mischer gekoppelt ist und an seinen Ausgang ein moduliertes Hochfrequenz-Signal bereitstellt.

Gemäß dem vorliegenden Prinzip werden zwei Spiegelfrequenz unterdrückende Mischer zur Bereitstellung eines modulierten Lokaloszillatorsignals zur Speisung des Frequenzumsetzers eingesetzt, welche vorteilhafterweise an ihrem Ausgang dieses Lokaloszillatorsignal mit einem exakten Phasenversatz von 90° als in Inphase- und Quadraturkomponente zerlegtes Signal bereitstellen. Das vorliegende Prinzip kombiniert dadurch die Vorteile einer Spiegelfrequenz unterdrückenden Mischung mit den Vorteilen einer komplexwertigen Signalverarbeitung im nachgeschalteten Frequenzumsetzer. Zudem ist eine verhältnismäßig geringe Anforderung an die Paarungstoleranzen und Bauteiltoleranzen der verwendeten Bauelemente erforderlich, so daß das vorliegende Schaltungsprinzip im Massenherstellungsverfahren kostengünstig realisierbar ist.

Die beiden beschriebenen Spiegelfrequenz unterdrückenden Mischer ersetzen einen Phasenschieber mit nachgeschaltetem, lediglich einen Spiegelfrequenz unterdrückenden Mischer, dessen Lokaloszillatorfrequenz die Sende-Trägerfrequenz bereitstellt. Das vorliegende Prinzip erlaubt daher weiterhin eine deutlich verbesserte Performance bei zugleich deutlich geringerer Stromaufnahme in Senderichtung.

Die beiden Spiegelfrequenz unterdrückenden Mischer arbeiten gemäß dem vorliegenden Prinzip als Modulatoren und werden so angesteuert, daß die unterschiedlichen Phasenlagen der Eingangssignale der Spiegelfrequenz unterdrückenden Mischer an deren Ausgängen zwei um 90° zueinander phasenverschobene Signalkomponenten bereitstellen, welche als Inphase- und Quadratur-Komponente des modulierten, niederfrequenten Frequenzanteils bereitgestellt sind. In den Frequenzumsetzer werden diese modulierten Inphase- und Quadratur-Komponenten anschließend auf die gewünschte Trägerfrequenz hochgesetzt. Vorteilhafterweise haben dabei die Bauteiltoleranzen des Frequenzumsetzers keinen Einfluß auf die Spiegelfrequenzunterdrückung des Modulationssignals.

Das vorliegende Prinzip ist insbesondere für eine Vektormodulation geeignet.

In einer vorteilhaften Ausführungsform der vorliegenden Erfindung ist ein Frequenzteiler zur Kopplung der Spiegelfrequenz unterdrückenden Mischer mit dem Bezugssignaleingang vorgesehen.

Der Frequenzteiler ist eingangsseitig bevorzugt mit einem der beiden Signalkomponenten-Eingängen des Frequenzumsetzers zur Zuführung eines Bezugssignals angeschlossen.

Hierdurch steht am Eingang der beiden Spiegelfrequenz unterdrückenden Mischer bevorzugt eine verhältnismäßig geringe Trägerfrequenz bereit, auf die das Modulationssignal aufmoduliert wird.

In einer weiteren, bevorzugten Ausführungsform der vorliegenden Erfindung haben die beiden Spiegelfrequenz unterdrückenden Mischer je ein erstes Eingangspaar, welches jeweils mit einem komplexwertigen Signalausgang des Frequenzteilers verbunden ist.

Zur Zuführung eines komplexwertigen, niederfrequenten Trägersignals kann je ein Eingangspaar der beiden Spiegelfrequenz unterdrückenden Mischer bevorzugt unmittelbar an den komplexwertigen Signalausgang des Frequenzteilers angeschlossen sein.

In einer weiteren, bevorzugten Ausführungsform der vorliegenden Erfindung haben die Spiegelfrequenz unterdrückenden Mischer je ein zweites Eingangspaar, wobei dem ersten Spiegelfrequenz unterdrückenden Mischer an seinem zweiten Eingangspaar das Modulationssignal bezüglich einer Signalkomponente invertiert und dem zweiten Spiegelfrequenz unterdrückenden Mischer an seinem zweiten Eingangspaar das Modulationssignal bezüglich seiner Signalkomponenten vertauscht zugeführt wird.

Die Invertierung einer der beiden Signalkomponenten zur Zuführung des Modulationssignals zum ersten Spiegelfrequenz unterdrückenden Mischer kann bei symmetrischer Schaltungsauslegung in besonders einfacher Weise durch Vertauschen der beiden, das entsprechende symmetrische Signal beziehungsweise die entsprechende symmetrische Signalkomponente führenden Leitungen des entsprechenden Leitungspaars erzielt werden.

Bei dem zweiten Spiegelfrequenz unterdrückenden Mischers werden die Signalkomponenten des komplexwertigen Signals beispielsweise dadurch vertauscht, daß deren Zuführung bezüglich des ersten Spiegelfrequenz unterdrückenden Mischers vertauscht ist.

Eine derartige Signalzuführung führt insgesamt dazu, daß die Modulatoren, das heißt die beiden Spiegelfrequenz unterdrükkenden Mischer, eine zueinander um 90° phasenverschobene Bezugsphase für die Modulation haben, so daß an deren Ausgängen zwei Signalkomponenten bereitstehen, welche zueinander gerade die gewünschte Phasenverschiebung von 90° haben und demnach eine Inphase- und eine Quadraturkomponente des modulierten Zwischenfrequenzsignals bilden.

Die invertierte Signalzuführung einer Signalkomponente am zweiten Eingangspaar des ersten Spiegelfrequenz unterdrückenden Mischers bewirkt eine Phasenverschiebung von -90°, während die Vertauschung der Signalkomponenten am zweiten Eingangspaar des zweiten Spiegelfrequenz unterdrückenden Mischers eine Verschiebung der Phasenlage des Modulationssignals um 180° bewirkt.

In einer weiteren, bevorzugten Ausführungsform der vorliegenden Erfindung ist der Frequenzteiler als Flip-Flop-Schaltung ausgebildet, welche zwei zueinander um 90° phasenverschobene Signalausgänge hat. Derartige Flip-Flops sind mit geringem schaltungstechnischem Aufwand aufbaubar.

In einer weiteren, bevorzugten Ausführungsform der vorliegenden Erfindung ist zur Kopplung der Ausgänge der beiden Spiegelfrequenz unterdrückenden Mischer mit dem zweiten Eingang des Frequenzumsetzers je ein Tiefpaßfilter vorgesehen. Die Tiefpaßfilter dienen insbesondere der Unterdrückung unerwünschter, durch die Modulation beziehungsweise Signalmultiplikation in den Spiegelfrequenz unterdrückenden Mischern entstehenden, höheren harmonischen Frequenzanteile.

In einer weiteren, bevorzugten Ausführungsform der vorliegenden Erfindung ist an dem Nutzsignaleingang der Sendeanordnung ein Digital/Analog-Wandler mit seinem Ausgang angeschlossen.

Eingangsseitig am Digital/Analog-Wandler ist bevorzugt eine ein digitales, zu sendendes Nutzsignal bereitstellende, digitale Signalverarbeitungseinheit angeschlossen, welche üblicherweise als Basisbandblock bezeichnet wird und die an ihrem Ausgang Gauß-gefilterte Signale bereitstellt.

Weitere Einzelheiten und Ausgestaltungen der Erfindung sind Gegenstand der Unteransprüche.

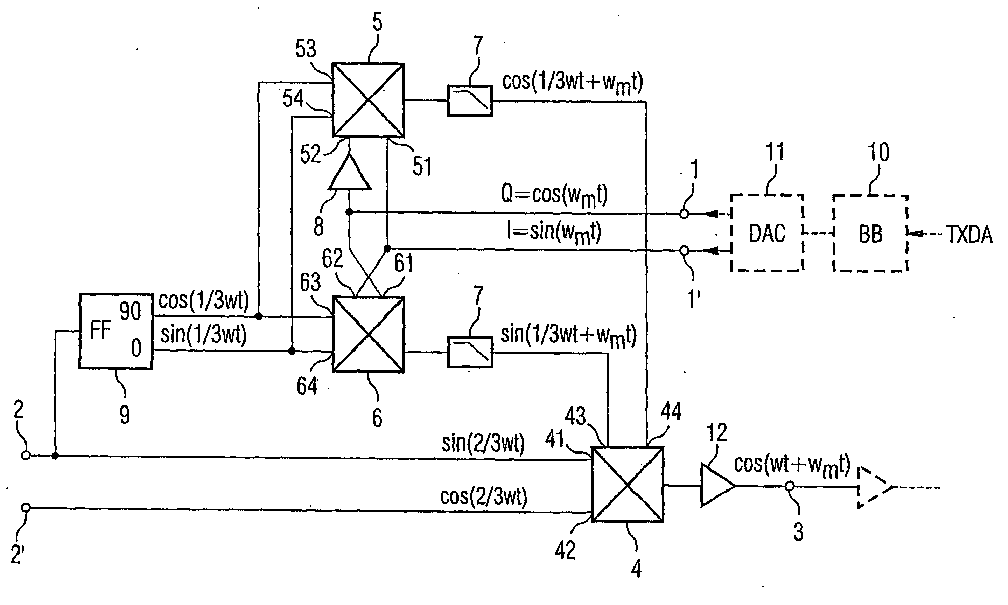

Die Erfindung wird nachfolgend an einem Ausführungsbeispiel anhand der Zeichnung näher erläutert.

Es zeigt:
die Figur ein vereinfachtes Blockschaltbild einer beispielhaften Ausführungsform der Sendeanordnung gemäß vorliegendem Prinzip.

Die Figur zeigt einen Mobilfunksender zur digitalen Kommunikation über einen Funkkanal. Die Sendeanordnung weist einen Nutzsignaleingang 1, 1' zum Zuführen eines komplexwertigen Modulationssignals cos ωₘt, sin ωₘt, einen Bezugssignaleingang 2, 2' zum Zuführen eines komplexwertigen Bezugssignals cos 2/3ωt, sin 2/3ωt sowie einen Ausgang 3 auf, an dem das in eine hochfrequente Lage versetzte, vom Modulationssignal cos ωₘt, sin ωₘt abgeleitete und auf einen hochfrequenten Träger aufmodulierte Signal cos(ωt+ωₘt) abgreifbar ist.

Die Sendeanordnung umfaßt weiterhin einen als Aufwärts-Frequenzumsetzer ausgebildeten Mischer 4 sowie zwei als Modulatoren betriebene, Spiegelfrequenz unterdrückende Mischer 5, 6, welche wie nachfolgend beschrieben miteinander verschaltet sind:

Der Frequenzumsetzer 4 weist ein erstes Paar von Eingängen zum Zuführen je einer Signalkomponente eines komplexwertigen Signals 41, 42 auf, der mit dem Bezugssignaleingang 2, 2' zum Zuführen des komplexwertigen Bezugssignals an den Frequenzumsetzer 4 verbunden ist. Ein zweites Eingangspaar 43, 44 des Frequenzumsetzers 4 ist mit Ausgängen der Spiegelfrequenz unterdrückenden Mischer 5, 6 gekoppelt, wobei der Ausgang des Spiegelfrequenz unterdrückenden Mischers 5 mit einem der beiden Eingangsklemmen 44 des zweiten Eingangs des Frequenzumsetzers 4, und der Ausgang des zweiten Spiegelfrequenz unterdrückenden Mischers 6 mit einer weiteren Eingangsklemme 43 des zweiten Eingangs des Frequenzumsetzers 4 gekoppelt ist. Zwischen Ausgang der Spiegelfrequenz unterdrückenden Mischer 5, 6 und Eingang 43, 44 des Frequenzumsetzers 4 ist jeweils ein Tiefpaßfilter 7 geschaltet.

Die Spiegelfrequenz unterdrückenden Mischer 5, 6 weisen jeweils ein erstes und ein zweites Eingangspaar auf. Das erste Eingangspaar 51, 52 des ersten Spiegelfrequenz unterdrückenden Mischers 5 und das erste Eingangspaar 61, 62 des zweiten Spiegelfrequenz unterdrückenden Mischers 6 sind jeweils mit dem Nutzsignaleingang 1, 1' zuzuführen eines komplexwertigen Modulationssignals cos ωₘt, sin ωₘt gekoppelt. Zum Erzielen einer Phasenverschiebung von -90° bei der Zuführung des komplexwertigen Nutzsignals an das komplexwertige erste Eingangspaar 51, 52 des ersten Modulators 5 ist an einem der beiden Eingangsklemmen, nämlich an Klemme 52, ein Inverter 8 vorgeschaltet. Der Inverter 8 ist demnach zwischen Eingangsklemme des Nutzsignaleingangs 1 und Eingangsklemme 52 des Mischereingangs 5 geschaltet. Die Eingangsklemme 1' ist mit der Eingangsklemme 51 bezüglich der Signalphase unmittelbar verbunden. Die Signalinvertierung mittels des Inverters 8 ist in vorliegender Ausführung mit jeweils symmetrischer Signalübertragung der orthogonalen Signalkomponenten in einfacher Weise durch Vertauschen der beiden Leitungen ermöglicht, die das am Eingang 52 zuführbare Signal führen.

Am Eingang 61, 62 ist das Nutzsignal mit einer Phasenverdrehung von 180° zugeführt. Dies ist dadurch erzielt, daß bezüglich der Signalzuführung am Modulator 5 bei der Signalzuführung am Modulator 6 die das komplexwertige Nutzsignal führenden Leitungen zwischen Nutzsignaleingang 1, 1' und Modulatoreingang 61, 62 vertauscht sind.

Neben den Nutzsignaleingängen 51, 52; 61, 62 weisen die Modulatoren 5, 6 weiterhin je einen Eingang zum Zuführen eines komplexwertigen Trägersignals cos 1/3ωt, sin 1/3ωt mit einer geringen Trägerfrequenz auf. Dieses komplexwertige Zwischenfrequenz-Trägersignal cos 1/3ωt, sin 1/3ωt ist mit einem als Frequenzteiler arbeitenden Flip-Flop 9 bereitgestellt, welches zwei zueinander um 90° phasenverschobene Signale jeweils mit der Trägerfrequenz für die Modulation aufweist. Der Ausgang des Frequenzteilers 9 ist zum einen mit dem Eingangspaar 53, 54 des Modulators 5 und zum anderen mit dem Eingangspaar 63, 64 des Modulators 6 verbunden. Weiterhin weist Frequenzteiler 9 einen Bezugssignaleingang zum Zuführen einer Signalkomponente des Bezugssignals cos 2/3ωt auf, der mit einer der beiden Eingangsklemmen 2 des Bezugssignaleingangs 2, 2' der Sendeanordnung verbunden ist. Der als Flip-Flop ausgebildete Frequenzteiler 9 führt eine Frequenzteilung durch zwei durch.

An den Bezugssignaleingang 2, 2' ist zum Bereitstellen des komplexwertigen Bezugssignals cos 2/3ωt, sin 2/3ωt beispielsweise über einen Frequenzteiler, der ebenfalls als Flip-Flop ausgebildet sein kann, ein spannungsgesteuerter Oszillator anschließbar.

Über einen Funkkanal zu übertragende Daten werden in einer Basisband-Signalverarbeitungseinheit 10 digital aufbereitet und in einer nachgeschalteten Digital/Analog-Wandlereinheit 11, welche den Ausgang des Basisbandblocks 10 mit dem Eingang 1, 1' der Sendeanordnung koppelt, in analoge Signale gewandelt. Über einen Verstärker 12 ist der Ausgang des Frequenzumsetzers 4 mit dem Ausgang 3 der Sendeanordnung gekoppelt. An dem Ausgang 3 der Sendeanordnung ist, beispielsweise über weitere Verstärker, eine Sendeantenne zur Anbindung der Sendeanordnung an einen Funkkanal ankoppelbar.

Die Funktionsweise der angegebenen Sendeanordnung beruht auf dem Prinzip, daß eine mit den Spiegelfrequenz unterdrückenden Mischern 5, 6 ermöglichte Vektormodulation bei verhältnismäßig geringen Frequenzen, im vorliegenden Fall bei ca. 800 MHz erfolgt und daß aufgrund der Verschaltung der Spiegelfrequenz unterdrückenden Mischer 5, 6 mit dem Frequenzumsetzer 4 am Eingang 43, 44 des Frequenzumsetzers 4, trotz der vorgeschalteten Spiegelfrequenz unterdrückenden Modulation dennoch ein komplexwertiges, moduliertes Signal bereitsteht, welches im Mischer 4 auf die gewünschte Sende-Trägerfrequenz von im vorliegenden Fall ca. 2,4 GHz umgesetzt wird.

Im einzelnen ist dabei gemäß dem vorliegenden Ausführungsbeispiel am Bezugssignaleingang 2, 2' ein komplexwertiges Bezugssignal mit einer Frequenz zuführbar, welche zwei Dritteln der am Ausgang 3 bereitgestellten Trägerfrequenz ω entspricht. Der Frequenzteiler 9 halbiert diese Bezugsfrequenz, so daß an den Bezugsfrequenzeingängen 53, 54; 63, 64 der Modulatoren 5, 6 eine verhältnismäßig geringe Trägerfrequenz bereitsteht, welche im vorliegenden Ausführungsbeispiel einem Drittel der späteren Sende-Trägerkreisfrequenz ω entspricht. Die Spiegelfrequenz unterdrückenden und als Modulatoren arbeitenden Mischer 5, 6 erhalten das Modulationssignal derart zugeführt, daß sich eine veränderte Bezugsphase für die Modulation ergibt, welche letztendlich bewirkt, daß ausgangsseitig an den beiden Spiegelfrequenz unterdrückenden Mischern 5, 6 jeweils eine Inphase- beziehungsweise eine Quadraturkomponente des auf ein Drittel der Trägerfrequenz modulierten Nutzsignals bereitsteht. Hierfür ist wie erläutert dem ersten Spiegelfrequenz unterdrückenden Mischer 5 das Nutzsignal um -90° phasenverschoben und dem zweiten Spiegelfrequenz unterdrückenden Mischer 6 das Nutzsignal um 180° phasenverschoben und jeweils als komplexwertiges Nutzsignal zugeführt.

Der ebenfalls als Spiegelfrequenz unterdrückender Mischer ausgebildete Frequenzumsetzer 4 mischt die Signale cos(1/3ωt+ωₘt), sin(1/3ωt+ωₘt) und sin(2/3ωt), cos(2/3ωt) zu einem auf die Trägerfrequenz ω modulierten Sendesignal, welches sich beschreiben läßt durch cos (ω·t + ωₘ·t).

Beispielsweise bei einem gewünschten Sendeband um 2,4 GHz kann die Modulation des Nutzsignals auf einen Träger bei lediglich 800 MHz erfolgen. Trotz der Vektormodulation bei verhältnismäßig niedriger Trägerfrequenz ermöglicht es die vorliegende Sendeanordnung, nicht auf eine Image Rejection-Architektur zu verzichten. Die Spiegelfrequenz des Modulationssignals wird dabei direkt beim Modulieren mit den Spiegelfrequenz unterdrückenden Mischern 5, 6 unterdrückt. Die Ausgangssignale an den Modulatoren 5, 6 sind dabei zueinander gerade um 90° phasenverschoben, so daß sie als Inphase- und Quadraturkomponente des modulierten, niederfrequenten Signals direkt dem Frequenzumsetzer 4 zugeführt werden können. In diesem weiteren Spiegelfrequenz unterdrückenden Mischer 4 werden die modulierten Frequenzanteile schließlich auf die Sende-Trägerfrequenz ω hochgesetzt. Die Toleranzen dieses Mischers 4 haben dabei keinen Einfluß auf die Spiegelfrequenzunterdrückung des Modulationssignals. Die vorliegende Sendeanordnung ist besonders stromsparend betreibbar, ist weitestgehend von Produktionstoleranzen der Bauelemente sowie deren Fehlanpassungen unabhängig und bietet dennoch eine gute Spiegelfrequenzunterdrückung des Modulationssignals.

Die Vertauschung beziehungsweise Invertierung in der Signalzuführung an den Eingängen der Mischer 5, 6 kann in alternativen Ausführungsformen auch bei der Bezugssignalzuführung anstelle, wie gezeigt, bei der Nutzsignalzuführung erfolgen.

Auch die Frequenzaufteilung kann im Rahmen der Erfindung anstelle der gezeigten ein Drittel/zwei Drittel-Aufteilung beispielsweise als eine ein Viertel/Drei Viertel-Aufteilung oder in anderer Weise erfolgen.

Prinzipiell könnte das vorliegende Prinzip auch sinngemäß für Empfangsanordnungen des Mobilfunks angewendet werden.

### Bezugszeichenliste

- 1: Modulationssignaleingang
- 1': Modulationssignaleingang
- 2: Bezugssignaleingang
- 2': Bezugssignaleingang
- 3: Ausgang
- 4: Frequenzumsetzer
- 5: spiegelfrequenzunterdrückender Mischer
- 6: spiegelfrequenzunterdrückender Mischer
- 7: Tiefpaßfilter
- 8: Inverter
- 9: Frequenzteiler
- 10: Basisband-Signalverarbeitungsblock
- 11: Digital/Analog-Wandler
- 12: Verstärker
- 41: Bezugssignaleingang
- 42: Bezugssignaleingang
- 43: zweiter Eingang
- 44: zweiter Eingang
- 51: Modulationssignaleingang
- 52: Modulationssignaleingang
- 61: Modulationssignaleingang
- 62: Modulationssignaleingang
- 53: Bezugssignaleingang
- 54: Bezugssignaleingang
- 63: Bezugssignaleingang
- 64: Bezugssignaleingang

## Patentansprüche

1. Sendeanordnung, insbesondere für den Mobilfunk, aufweisend
- einen Nutzsignaleingang (1, 1') zum Zuführen eines komplexwertigen Modulationssignals (cos ωₘt, sin ωₘt)
- einen Bezugssignaleingang (2, 2') zum Zuführen eines komplexwertigen Bezugssignals (cos 2/3ωt, sin 2/3ωt) mit einer Bezugsfrequenz (2/3·ω),
- einen ersten spiegelfrequenzunterdrückenden Mischer (5) und einen zweiten spiegelfrequenzunterdrückenden Mischer (6), die jeweils mit dem Modulationssignal (cos ωₘt, sin ωₘt) und einem vom Bezugssignal abgeleiteten Signal (cos 1/3ωt, sin 1/3ωt) so angesteuert sind, daß die an ihren Ausgängen bereitgestellten Signalkomponenten (cos 1/3ωt+ωₘt, sin 1/3ωt+ωₘt) zueinander um 90° phasenverschoben sind und gemeinsam ein komplexwertiges, moduliertes Zwischenfrequenzsignal bilden, und
- einen Frequenzumsetzer (4), der mit einem ersten Eingang (41, 42) mit dem Bezugssignaleingang (2, 2') und mit einem zweiten Eingang (43; 44) mit den Ausgängen der spiegelfrequenzunterdrückenden Mischer (5, 6) gekoppelt ist und an seinen Ausgang ein moduliertes HochfrequenzSignal (cos ωt+ωₘt) bereitstellt.

2. Sendeanordnung nach Anspruche 1,
**dadurch gekennzeichnet, daß**
ein Frequenzteiler (9) zur Kopplung der spiegelfrequenzunterdrückenden Mischer (5, 6) mit dem Bezugssignaleingang (2, 2') vorgesehen ist.

3. Sendeanordnung nach Anspruch 2,
**dadurch gekennzeichnet, daß**
die spiegelfrequenzunterdrückenden Mischer (5, 6) je ein erstes Eingangspaar (53, 54; 63, 64) zur Zuführung je eines komplexwertigen Signals haben, welches jeweils mit einem komplexwertigen Signalausgang des Frequenzteilers (9) verbunden ist.

4. Sendeanordnung nach Anspruch 3,
**dadurch gekennzeichnet, daß**
die spiegelfrequenzunterdrückenden Mischer (5, 6) je ein zweites Eingangspaar (51, 52; 61, 62) haben, wobei dem ersten spiegelfrequenzunterdrückenden Mischer (5) das Modulationssignal (cos ωₘt, sin ωₘt) an seinem zweiten Eingangspaar (51, 52) bezüglich einer der beiden Signalkomponenten invertiert und dem zweiten spiegelfrequenzunterdrückenden Mischer (6) an seinem zweiten Eingangspaar (61, 62) das Modulationssignal (cos ωₘt, sin ωₘt) bezüglich seiner Signalkomponenten vertauscht zugeführt wird.

5. Sendeanordnung nach einem der Ansprüche 2 bis 4,
**dadurch gekennzeichnet, daß**
der Frequenzteiler (9) als Flip-Flop mit zwei zueinander um 90° phasenverschobenen Signalausgängen ausgebildet ist.

6. Sendeanordnung nach einem der Ansprüche 1 bis 5,
**dadurch gekennzeichnet, daß**
zur Kopplung der Ausgänge der spiegelfrequenzunterdrückenden Mischer (5, 6) mit dem zweiten Eingang (43, 44) des Frequenzumsetzers (4) jeweils ein Tiefpaß-Filter (7) vorgesehen ist.

7. Sendeanordnung nach einem der Ansprüche 1 bis 6,
**dadurch gekennzeichnet, daß**
an den Nutzsignaleingang (1, 1') der Sendeanordnung ein Digital/Analog-Wandler (11) mit seinem Ausgang angeschlossen ist.

## Claims

1. Transmission arrangement, in particular for mobile radio, having
- a payload signal input (1, 1') for supplying a complex modulation signal (cos ωₘt, sin ωₘt)
- a reference signal input (2, 2') for supplying a complex reference signal (cos 2/3ωt, sin 2/3ωt) at a reference frequency (2/3·ω),
- a first mirror-image frequency suppressing mixer (5) and a second mirror-image frequency suppressing mixer (6) which are respectively driven by the modulation signal (cos ωₘt, sin ωₘt) and a signal (cos 1/3ωt, sin 1/3ωt) which is derived from the reference signal such that the signal components (cos 1/3ωt+ωₘt, sin 1/3ωt+ωₘt) which are produced at its outputs are phase-shifted through 90° with respect to one another and together form a complex, modulated intermediate frequency signal, and
- a frequency converter (4), which is coupled by a first input (41, 42) to the reference signal input (2, 2') and is coupled by a second input (43, 44) to the outputs of the mirror-image frequency suppressing mixer (5, 6) and at whose output a modulated radio-frequency signal (cos ωt+ωₘt) is produced.

2. Transmission arrangement according to Claim 1,
**characterized in that**
a frequency divider (9) is provided in order to couple the mirror-image frequency suppressing mixers (5, 6) to the reference signal input (2, 2').

3. Transmission arrangement according to Claim 2,
**characterized in that**
the mirror-image frequency suppressing mixers (5, 6) each have a first input pair (53, 54; 63, 64) for supplying a respective complex signal, which is in each case connected to a complex signal output of the frequency divider (9).

4. Transmission arrangement according to Claim 3,
**characterized in that**
the mirror-image frequency suppressing mixers (5, 6) each have a second input pair (51, 52; 61, 62), with the first mirror-image frequency suppressing mixer (5) being supplied with the modulation signal (cos ωₘt, sin ωₘt) at its second input pair (51, 52), inverted with respect to one of the two signal components, and with the second mirror-image frequency suppressing mixer (6) being supplied at its second input pair (61, 62) with the modulation signal (cos ωₘt, sin ωₘt) interchanged with respect to its signal components.

5. Transmission arrangement according to one of Claims 2 to 4,
**characterized in that**
the frequency divider (9) is in the form of a flipflop with two signal outputs which are phase-shifted through 90° with respect to one another.

6. Transmission arrangement according to one of Claims 1 to 5,
**characterized in that**
a low-pass filter (7) is in each case provided in order to couple the outputs of the mirror-image frequency suppressing mixers (5, 6) to the second input (43, 44) of the frequency converter (4).

7. Transmission arrangement according to one of Claims 1 to 6,
**characterized in that**
the output of a digital/analog converter (11) is connected to the payload signal input (1, 1').

## Revendications

1. Dispositif émetteur, notamment pour la téléphonie mobile, comportant :
- une entrée de signal utile (1, 1') pour l'amenée d'un signal de modulation à valeurs complexes (cos ωₘt, sin ωₘt),
- une entrée de signal de référence (2, 2') pour l'amenée d'un signal de référence à valeurs complexes (cos 2/3ωt, sin 2/3ωt) avec une fréquence de référence (2/3 • ω),
- un premier mélangeur (5) affaiblisseur de fréquence image et un deuxième mélangeur (6) affaiblisseur de fréquence image qui sont commandés respectivement avec le signal de modulation (cos ωₘt, sin ωₘt) et avec un signal (cos 1/3ωt, sin 1/3ωt) déduit du signal de référence de telle sorte que les composantes de signal (cos 1/3ωt + ωₘt, sin 1/3ωt + ωₘt) fournies à leurs sorties sont déphasées de 90° l'une par rapport à l'autre et forment conjointement un signal à fréquence intermédiaire modulé à valeurs complexes, et
- un convertisseur de fréquence (4) qui est relié par une première entrée (41, 42) à l'entrée de signal de référence (2, 2') et par une deuxième entrée (43, 44) aux sorties des mélangeurs (5, 6) affaiblisseurs de fréquence image et qui fournit à sa sortie un signal à haute fréquence modulé (cos ωt + ωₘt).

2. Dispositif émetteur selon la revendication 1,
**caractérisé par le fait qu'**un diviseur de fréquence (9) est prévu pour relier les mélangeurs (5, 6) affaiblisseurs de fréquence image à l'entrée de signal de référence (2, 2').

3. Dispositif émetteur selon la revendication 2,
**caractérisé par le fait que** les mélangeurs (5, 6) affaiblisseurs de fréquence image ont chacun un premier couple d'entrées (53, 54 ; 63, 64) qui est destiné à l'amenée à chaque fois d'un signal à valeurs complexes et qui est relié à chaque fois à une sortie de signal à valeurs complexes du diviseur de fréquence (9).

4. Dispositif émetteur selon la revendication 3,
**caractérisé par le fait que** les mélangeurs (5, 6) affaiblisseurs de fréquence image ont chacun un deuxième couple d'entrées (51, 52 ; 61, 62), le premier mélangeur (5) affaiblisseur de fréquence image recevant à son deuxième couple d'entrées (51, 52) le signal de modulation (cos ωₘt, sin ωₘt) après une inversion concernant l'une des deux composantes de signal et le deuxième mélangeur (6) affaiblisseur de fréquence image recevant à son deuxième couple d'entrées (61, 62) le signal de modulation (cos ωₘt, sin ωₘt) après une permutation concernant ses composantes de signal.

5. Dispositif émetteur selon l'une des revendications 2 à 4,
**caractérisé par le fait que** le diviseur de fréquence (9) est conçu comme une bascule bistable avec deux sorties de signal déphasées de 90° l'une par rapport à l'autre.

6. Dispositif émetteur selon l'une des revendications 1 à 5,
**caractérisé par le fait que**, pour relier les sorties des mélangeurs (5, 6) affaiblisseurs de fréquence image à la deuxième entrée (43, 44) du convertisseur de fréquence (4), il est prévu à chaque fois un filtre passe-bas (7).

7. Dispositif émetteur selon l'une des revendications 1 à 6,
**caractérisé par le fait qu'**un convertisseur numérique / analogique (11) est raccordé par sa sortie à l'entrée de signal utile (1, 1') du dispositif émetteur.
